(19) Europäisches Patentamt
European Patent Office
Office européen des brevets

(11) Veröffentlichungsnummer: **0 226 742**
**B1**

(12) **EUROPÄISCHE PATENTSCHRIFT**

(45) Veröffentlichungstag der Patentschrift: 05.12.90

(51) Int. Cl.⁵: **G 01 L 9/08, G 01 L 23/10**

(21) Anmeldenummer: 86114305.5

(22) Anmeldetag: 16.10.86

(54) Druckaufnehmer für Druckmessungen unter hohen Temperaturen.

(30) Priorität: 21.12.85 DE 3545682

(43) Veröffentlichungstag der Anmeldung:
01.07.87 Patentblatt 87/27

(45) Bekanntmachung des Hinweises auf die
Patenterteilung:
05.12.90 Patentblatt 90/49

(84) Benannte Vertragsstaaten:
DE FR GB IT SE

(56) Entgegenhaltungen:
AT-B- 280 654
AT-B- 349 796
GB-A-2 154 323
US-A-4 052 628
US-A-4 211 951
US-E- 29 755

J. TICHY et al. "Piezoelektrische Messtechnik",
1980 SPRINGER-VERLAG, Berlin, Heidelberg,
New York

(73) Patentinhaber: FEV Forschungsgesellschaft für
Energietechnik und Verbrennungsmotoren mbH
Jülicher Strasse 342-352
D-5100 Aachen (DE)

(72) Erfinder: Gürich, Gunter Lothar
Nordhoffstrasse 16
D-5100 Aachen (DE)

(74) Vertreter: Fischer, Friedrich B., Dr.-Ing.
Saarstrasse 71
D-5000 Köln 50 (Rodenkirchen) (DE)

Courier Press, Leamington Spa, England.

## Beschreibung

Die Erfindung bezieht sich auf einen Druckaufnehmer mit einem piezoelektrischen Meßelement für Druckmessungen unter hohen Temperaturen, bei dem der zu messende Druck auf mindestens ein piezoelektrisches Meßelement eine Schubspannung ausübt, welche auf die eine Seite des piezoelektrischen Meßelements durch einen Stempel übertragen wird, und bei dem auf der anderen Seite des piezoelektrischen Meßelements ein Widerlager angeordnet ist, das die Kraft aufnimmt und zum Gehäuse weiterleitet, wobei der Stempel, das piezoelektrische Meßelement und das Widerlager in Querrichtung unter Vorspannung gehalten sind.

Die Druckmessung in Brennkraftmaschinen ist seit dem Beginn der Motorentwicklung eines der wichtigsten Hilfsmittel zur Beurteilung der Verbrennung. Der Druck ist eine aussagefähige Zustandsgröße für die thermodynamischen Vorgänge im Motor. Zunehmende Bedeutung erlangt die Druckmessung daher auch für die Betriebsüberwachung großer Dieselmotoren. Voraussetzung für solche Anwendungen ist eine besonders robuste Ausführung des hochbeanspruchten Aufnehmers, so daß auch ohne Zwangskühlung hohe Standzeiten erreicht werden. Die Anforderungen an einen solchen Aufnehmer sind neben den genannten und den sonst für Druckaufnehmer üblichen vor allem weitgehende Temperaturunabhängigkeit des Übertragungsfaktors, Temperaturschock-Unempfindlichkeit und Übertemperatur-Sicherheit.

Zur Messung des Druckes im Verbrennungsmotor werden seit langem zwangsgekühlte Druckaufnehmer für thermodynamische Untersuchungen eingesetzt. Die piezoelektrische Meßtechnik, basierend auf dem Quarz-Einkristall, hat sich für diese Anwendung weitgehend durchgesetzt. Hauptproblem der Druckaufnehmer sind hohe mechanische und thermische, insbesondere schockartige Belastungen während der Verbrennung. Verbesserungsanstrengungen konzentrieren sich auf diese Probleme. Die Membran und ihre Befestigung, das Meßelement und die Materialien stehen dabei im Vordergrund.

Die begrenzte Lebensdauer gekühlter Aufnehmer, ihre schwierige Handhabung und andere Gründe sind ausschlaggebend für die Entwicklung ungekühlter Aufnehmer sowohl für Forschungs- und Entwicklungszwecke als auch besonders für Überwachungsaufgaben. Für ungekühlte Druckaufnehmer hat sich ebenfalls der piezoelektrische Effekt eingeführt.

Durch US—A—4 052 628 ist ein Druckaufnehmer mit einem piezoelektrischen Meßelement der eingangs bezeichneten Art bekannt geworden, bei dem der piezoelektrische Drucksensor auf Scherung beansprucht ist. Die keramischen piezoelektrischen Elemente sind durch Bolzen sandwichartig in einer Anordnung zusammengehalten, welche Kollektorplatten und ein Halteteil aufweist; mit dem Halteteil ist auch eine piezoelektrische Kompensationsanordnung durch Bolzen verbunden.

Die europäische Patentanmeldung 0016858 und US—A—4 503 351 beschreiben ein piezoelektrisches Wandlerelement zum Einbau in Druck-, Kraft- oder Beschleunigungsaufnehmer, mit wenigstens zwei auf Scherung beanspruchten planbearbeiteten Piezoplatten, die beidseitig eines zentralen Trägers angeordnet sind, und zwei außen an den Piezoplatten anliegenden kreissegmentförmigen Druckverteilungsstücken, wobei die Anordnung aus Druckverteilungsstücken, Piezoplatten und Träger durch ein sie außen umgebendes Kompressionsformstück unter Vorspannung zusammengehalten ist, und bei dem das verformungssteife, ein Langloch zur Aufnahme der Anordnung aus Druckverteilungsstücken, Piezoplatten und Träger aufweisende Kompressionsformstück auf die Druckverteilungsstücke aufgeschrumpft ist.

Der Erfindung liegt die Aufgabe zugrunde, einen neuen ungekühlten Druckaufnehmer für den Einsatz unter Hochtemperaturbedingungen zu schaffen, der den obigen Anforderungen weitgehend genügt und gegenüber bekannten Aufnehmertypen erhebliche Vorteile aufweist, insbesondere hinsichtlich der Meßgenauigkeit und der Betriebssicherheit.

Gemäß der Erfindung ist bei einem Druckaufnehmer mit einem piezoelektrischen Meßelement der eingangs bezeichneten Art vorgesehen, daß das Widerlager in Richtung der dem zu messenden Druck proportionalen Kraft mit dem Gehäuse verbunden ist. Vorzugsweise ist dabei das Widerlager auf der dem zu messenden Druck zugewandten Seite mit dem Gehäuse verbunden.

Dabei kann es zweckmäßig sein, daß bei im wesentlichen symmetrischer Ausbildung zwei einander gegenüberliegende Widerlager von einer Vorspannfeder umgeben sind, deren Vorspannung unabhängig von der Kraft ist, welche dem zu messenden Druck proportional ist.

Gemäß einer weiteren bevorzugten Ausführungsform ist vorgesehen, daß das Widerlager unmittelbar die Gegenkraft zu der Kraft aufnimmt, welche dem zu messenden Druck proportional ist, und weitere Vorteile ergeben sich, wenn das Widerlager im wesentlichen linienförmig an einem am piezoelektrischen Meßelement anliegenden Krafteinleitungselement auliegt, und wenn in diesem Fall das Krafteinleitungselement aus keramischem Material besteht.

Gemäß einer weiteren bevorzugten Ausführungsform ist vorgesehen, daß das piezoelektrische Meßelement aus einem Lithiumniobat-Einkristall mit einem Kristallschnitt von $(xyt)\psi = 22°$—$22,5°$ besteht.

Demgegenüber enthält der in US—A—4 052 628 beschriebene Druckaufnehmer zum Zwecke der Vorspannung der piezoelektrischen Elemente und der Krafteinleitungselemente in radialer Richtung eine Dehnschraube, die diese Elemente an einem zentralen Flansch festhält. Die Einleitung der Meßkraft in axialer Richtung erfolgt von einer Membran über einen ringförmigen Stempel auf zwei Kappen als Krafteinleitungselemente, die zugleich die Kraft der Vorspannschraube verteilen. Die Verbindung zwischen Stempel und Krafteinleitungselementen erfolgt formschlüssig. Da dynamische Drücke gemessen werden sollen, müssen die kraftübertragenden Flächen mittels der zentralen Befestigungsschraube am Gehäuse axial vorgespannt werden. Der Kraftfluß dieser Vorspannung geht also vom Gehäuse durch Befestigungsschraube, Piezoelemente und Krafteinleitungselemente in den Stempel, also den gleichen Übertragungsweg wie die Meßkraft. Durch die Belastung mit der Meßkraft im Betrieb werden die genannten Elemente im Kraftfluß deformiert. Hieraus resultiert eine Änderung der Vorspannkräfte. Hinzu kommt der Einfluß thermischer Dehnungen auf die Änderung der Vorspannung. Durch Deformation der Krafteinleitungselemente und somit auch der Auflageflächen der Vorspannschraube im Betrieb entstehen darüberhinaus Biegemomente auf die Vorspannschraube und somit auf die piezoelektrischen Meßelemente. Insbesondere bei thermischen Dehnungen wird die Vorspannung der krafteinleitenden Flächen zwischen Stempel und Krafteinleitungselementen sowie zwischen Vorspannschraube und Krafteinleitungselementen beeinflußt, und es werden Reibung sowie zusätzliche Biegemomente hervorgerufen. Biegemomente können zu Meßfehlern und zum Bruch der empfindlichen piezoelektrischen Platten führen. Diese Konstruktion macht außerdem Bohrungen durch die bruchempfindlichen piezoelektrischen Elemente erforderlich.

In der Europäischen Patentanmeldung 0016858 und in US—A—4 503 351 wird ein weiterer Druckaufnehmer mit Schereffekt-Piezoelement beschrieben. Bei diesem wird die Vorspannung durch einen aufgeschrumpften Ring erzeugt. Die Meßkraft wird über den Ring auf das Meßelement geleitet.

Diesem und dem vorgenannten Druckaufnehmer ist gemeinsam, daß die Vorspannung durch die Meßkraft beeinflußt werden kann, daß die Vorspannwege der Vorspannelemente extrem klein sind und daß das piezoelektrische Meßelement zwischen zwei weit auseinanderliegenden Stellen des Gehäuses eingespannt ist, nämlich beiderseits des Befestigungsgewindes. Dies macht zum einen eine äußerst eng tolerierte Fertigung und Montage der Vorspannelemente sowie des Gehäuses erforderlich; zum anderen wird der Spannungszustand des Meßelementes durch thermische und mechanische Dehnungen der zusammenwirkenden Elemente (Meßelement, Vorspannelement, Gehäuse und Befestigungselemente am Gehäuse) beeinflußt. Besonders durch hohe und wechselnde Temperaturen können hierdurch fehlerhafte Messungen verursacht werden. Unterschiedliche Anzugsmomente des Aufnehmers bei der Montage können bereits die Reproduzierbarkeit erheblich beeinträchtigen.

Demgegenüber werden bei dem Druckaufnehmer gemäß der Erfindung Widerlager, Vorspannelement und Krafteinleitungselemente so ausgebildet, daß die radiale Vorspannkraft durch die Meßkraft in vernachlässigbarem Maße verändert wird. Eine axiale Vorspannung wird nicht benötigt, da keine reibschlüssige Verbindung vorhanden ist, die einer solchen Vorspannung bedarf. Zungenförmige Widerlager sorgen für eine biegeweiche, zugsteife Kraftübertragung. Die Meßkraft ruft, soweit möglich, keine Biegemomente der Vorspannfeder und der piezoelektrischen Elemente hervor. Die Vorspannfeder ist frei tragend und als Biegeringfeder mit relativ großem Federweg im Vergleich zu Dehnschraube und Schrumpfring ausgeführt. Thermische Dehnungen haben aus den vorgenannten Gründen einen wesentlich geringeren Einfluß auf die Vorspannung; Fertigung und Montage des Vorspannelementes erfordern weniger enge Toleranzen als bei beiden oben genannten Ausführungen. Die Befestigung der Widerlager am Gehäuse auf der dem Meßdruck zugewandten Seite ermöglicht eine weitere Verringerung der thermischen Einflüsse, da sich axiale thermische Dehnungen weitgehend kompensieren lassen. Außerdem wird die Empfindlichkeit gegenüber weiteren thermisch bedingten oder bei der Montage hervorgerufenen Dehnungen ebenfalls vernachlässigbar. Diese Lösung eignet sich aus den genannten Gründen für Druckmessungen bei hohen und/oder schnell wechselnden Temperaturen, insbesondere in Brennkraftmaschinen, in sehr vorteilhafter Weise.

Ausführungsbeispiele der Erfindung werden anhand der Zeichnungen nachfolgend beschrieben.

Es zeigen:

Figur 1 schematisch den Aufbau eines piezoelektrischen Druckaufnehmers gemäß der Erfindung,

Figur 2 ein Ausführungsbeispiel eines piezoelektrischen Druckaufnehmers gemäß der Erfindung im Längsschnitt,

Figur 3 das Ausführungsbeispiel gemäß Figur 2 im Querschnitt,

Figur 4 ein weiteres Ausführungsbeispiel eines Druckaufnehmers gemäß der Erfindung im Längsschnitt,

Figur 5 ein weiteres Ausführungsbeispiel gemäß Figur 2 oder 4 im Querschnitt.

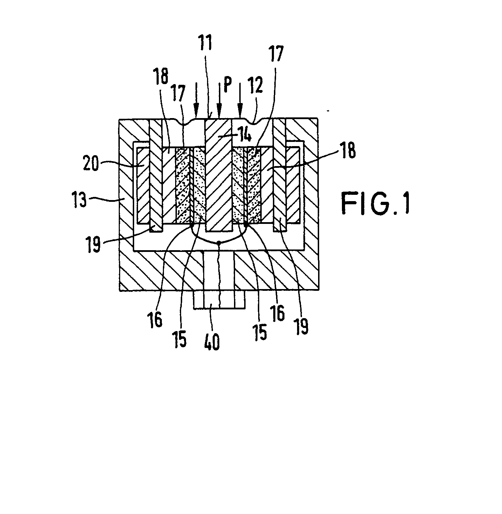

Eine schematische Darstellung eines Schertyp-Druckaufnehmers gemäß der Erfindung wird in Figur 1 an einem Aufnehmer mit zwei mechanisch parallel geschalteten Meßelementen gezeigt. Der Druck p wirkt auf Meßfläche 11. Membran 12 dichtet Aufnehmergehäuse 13 gegen den Brennraum ab. Die Druckkraft wird über Krafteinleitungsstück 14 — Stempel genannt — auf die Meßelemente übertragen, die seitlich des Stempels 14 angeordnet sind. Ein Meßelement besteht aus Zwischenteilen 15 zur elektrischen Isolierung, Elektroden 16 zur Abnahme der elektrischen Ladungen, piezoelektrischen Elementen 17 und Krafteinleitungsstücken 18. Widerlager 19 leiten die von den Meßelementen übertragene Kraft auf das Gehäuse 13. Die Meßelemente werden durch die Meßkraft auf Schub beansprucht.

Eine vorzugsweise ringförmige Vorspannfeder 20 sorgt für das Zusammenhalten der Meßelemente. Als Vorspannfeder könnten bei geeigneter Formgebung und Montage auf platzsparende Weise auch die Widerlager 19 dienen. Empfehlenswert ist jedoch die Aufteilung der Funktionen auf verschiedene Bauteile 19 und 20, da die Vorspannfeder hierbei nicht durch die Meßkraft beansprucht wird und somit von der Meßkraft unabhängig ist. Zur Vorspannung kann auch ein elastisch verformtes Innenteil dienen.

Die Isolierteile 15 können auch durch Kristalle ersetzt werden, so daß sich bei geeigneter Orientierung der Kristallschnitte und elektrischer Parallelschaltung der Übertragungsfaktor verdoppelt. Außerdem ist ein Vertauschen der Isolierteile 15 mit den Kristallen 17 sowie bei geeigneter Konstruktion der Fortfall der Krafteinleitungsstücke 18 möglich.

Die beschriebene Anordnung erfüllt die gestellte Aufgabe in vorteilhafter Weise:

Die Vorspannfeder stellt keinen Kraftnebenschluß zum Meßelement her, sie beeinflußt also die Meßkraft nicht. Sie liegt außerhalb des Meßkraftflusses; hierzu ist ein Federelement vorgesehen, das sich durch die Vorspannung selbst hält und nur mit den Widerlagern 19 verbunden ist, z.B. ein Schrumpfring, eine Biegeringfeder, Druckstücke mit Dehnschrauben, elastischer Bügel mit Schrauben etc.

Die Querempfindlichkeit des Druckaufnehmers in Richtung der Scherachse kann durch geeignete Kombination mehrerer gleicher Kristalle in geeigneter Orientierung und elektrischer Schaltung weitgehend verringert werden. Bei der Optimierung des Kristallschnittes kann die Querempfindlichkeit aus diesem Grunde unberücksichtigt bleiben.

Der Einfluß des Gehäuses auf die Meßkraft wird dadurch vermindert, daß Widerlager 19 und Stempel 14 auf der dem Druck zugewandten Seite mit dem Gehäuse 13 und der Membran 12 verbunden sind. Durch diese Maßnahme verringert sich der Wärmefluß durch das Meßelement und durch die Vorspannfeder 20 beträchtlich, wenn Abmessungen und Materialien entsprechend gewählt werden. Außerdem werden durch diese Maßnahme Zwangskräfte, die durch thermische Dehnungen im Stempel 14 und im Widerlager 19 entstehen könnten, erheblich vermindert.

Die Vorspannfeder ist ein einfach zu fertigendes Bauteil.

Fertigungstoleranzen, insbesondere der Vorspannfeder, beeinflussen die Meßkraft nur unwesentlich.

Die Lösung der obigen Aufgabe hängt auch von einem geeigneten piezoelektrischen Material und vom Kristallschnitt ab. Neben dem bisher verwendeten Quarz, der die erwähnten Nachteile hat, kommen für Hochtemperaturbedingungen nur wenige andere Kristalle in Frage. Wegen seiner hohen Curie-Temperatur, guten mechanischen und piezoelektrischen Eigenschaften und geringer Temperaturabhängigkeit sowie Stabilität seiner Eigenschaften wird Lithiumniobat als Modellmaterial bevorzugt. Gemäß einer bevorzugten Ausführungsform wird Lithiumniobat mit einem Schnitt $(xyt)\psi = 22°—22,5°$ verwendet. Die wichtigsten Eigenschaften dieses Kristalls sind.

Der Übertragungsfaktor für Scherkraft ist bei diesem Kristallschnitt erheblich größer als beim Transversal- oder Longitudinaleffekt in Quarz.

Der Übertragungsfaktor für Druckkraft ist ungefähr gleich Null, somit treten kein Einfluß von Vorspannungsänderungen oder Nichtlinearitäten der Vorspannfeder auf die Meßgröße auf; die Querempfindlichkeit des Aufnehmers in dieser Richtung ist ungefähr gleich Null.

Der pyroelektrische Koeffizient ist ungefähr gleich Null, somit treten hierdurch keine temperaturbedingten Meßsignale auf.

Der lineare Temperaturkoeffizient des Übertragungsfaktors ist ungefähr gleich Null, somit betragen in einem weiten Temperaturbereich bis 550 K systematische relative Meßfehler weniger als +/- 1% vom Meßwert.

Temperaturüberlastbarkeit des Kristalls besteht kurzfristig bis 1000 K, möglicherweise noch höher.

Eine quasistatische Kalibrierung bei Zimmertemperatur ist möglich und gültig bis über 550 K.

Zur Abnahme der elektrischen Ladungen von den piezoelektrischen Kristallen werden diese auf ihren Hauptseiten bevorzugt mit Elektroden versehen, die in Dünnschichttechnik, insbesondere durch Sputtern oder Aufdampfen, oder in Dickschichttechnik auszuführen sind.

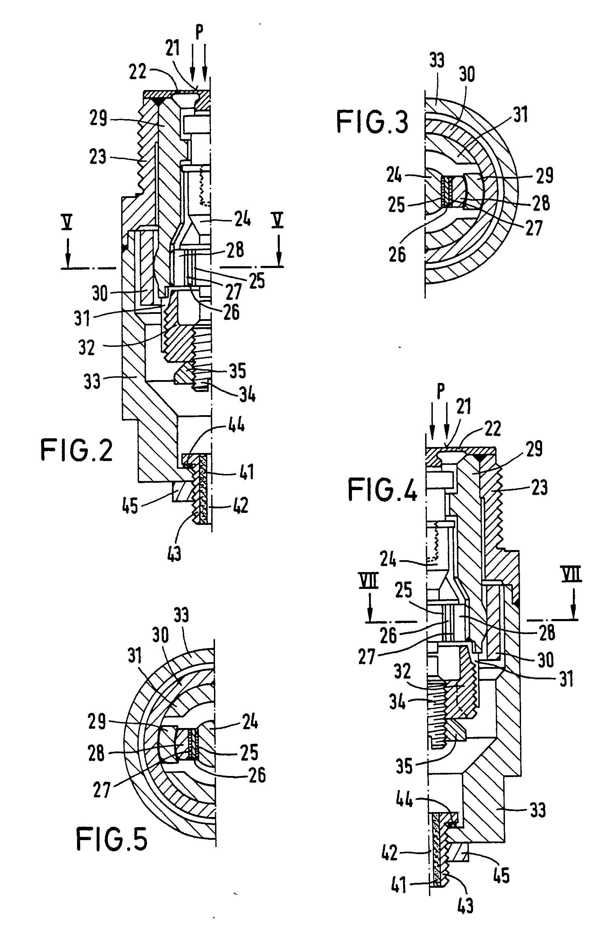

Weitere Einzelheiten der Erfindung sind im Längs- bzw Querschnitt in den Figuren 2 bis 5 dargestellt.

Der zu messende Brennrauminnendruck einer Brennkraftmaschine wirkt auf Meßfläche 21. Membran 22 dichtet Aufnehmergehäuse 23 gegen den Brennraum ab und überträgt die Meßkraft über ihren inneren Teil auf ein Krafteinleitungsstück 24, Stempel genannt. Der Stempel ist zweigeteilt ausgeführt. Beide Teile enthalten je einen ringförmigen Überstand, der in Verbindung mit einem dazwischenliegenden Überstand an Widerlagern 29 eine Überlastsicherung bzw. eine Sicherung gegen Herausfallen von Teilen bietet. Die formschlüssigen Verbindungsflächen beider Teile sind mittels eines Gewindes vorgespannt. Die Druckkraft im Stempel 24 übt auf Meßelemente zu beiden Seiten des Stempels 24 Schubkräfte aus, die von Widerlager 29 aufgenommen und auf das Gehäuse 23 übertragen werden. Die Meßelemente bestehen aus Isolierelementen 25, Elektroden 26, piezoelektrischen Elementen 27 und äußeren Krafteinleitungsteilen 28. Die Isolierelemente 25 bestehen aus Quarzglasscheiben der gleichen Abmessungen wie die piezoelektrischen Elemente 27 und können durch solche ersetzt werden. Die Elektroden 26 bestehen aus speziellen Ausdehnungslegierungen. Meßleitungen, hier nur angedeutet, sind an den Elektroden 26 hart angelötet und führen zu Stift 42 eines Miniatursteckers. Für die piezoelektrischen Elemente 27 wird der bevorzugte Kristallschnitt von Lithiumniobat verwendet, wie oben beschrieben.

Die Meßelemente werden mittels Vorspannfeder 30 vorgespannt. Die Vorspannfeder wird vorzugsweise als ringförmige, im Montagevorgang gespannte Biegefeder ausgeführt, um große Federwege zu erzielen. Die Vorspannkraft wird von dieser Feder vorzugsweise punktförmig auf die Widerlager 29 eingeleitet, um Kantenpressung und andere Zwangskräfte auf die piezoelektrischen Elemente 27 und Isolierelemente 25 zu verringern, wie in den Figuren 2 und 5 gezeigt. Mit Vorteil kann auch eine genau angepaßte Form der Widerlager 29 verwendet werden, um eine gleichmäßige Kraftverteilung zu gewährleisten, wie in den Figuren 3 und 4 dargestellt ist. Kantenpressung wird vermieden, indem die Krafteinleitungsstücke 28 mit stark gebrochenen Kanten ausgeführt werden, wie in den Figuren 3 und 4, oder aber mit einer im wesentlichen zylindrischen Oberfläche, wie in den Figuren 2 und 5. In diesem Fall werden die Vorspannkraft und die Meßkraft im wesentlichen linienförmig zwischen den Widerlagern 29 und den Krafteinleitungselementen 28 übertragen. Denkbar ist auch eine punktförmige Kraftübertragung, wie zwischen Vorspannfeder 30 und Widerlagern 29. Da die Meßkraft eine Schubspannung im Meßelement ausüben soll, ist diese Ausführung weniger empfehlenswert.

Sind die Krafteinleitungselemente 28 aus keramischem Material ausgeführt, so können die Isolierteile 25 und Elektroden 26 platzsparend entfallen. Zur Ableitung der Meßladungen werden in diesem Falle vorzugsweise Dickschichtelektroden auf Teilen der Keramikoberflächen angebracht sowie Meßleitungen angelötet.

Soll die Vorspannung einstellbar sein, so können gemäß den Figuren 2 bis 5 vorteilhaft Spannteile 31 eingeführt werden, die von Spannmuttern 32 über einen Konus an ihrer Verbindungsstelle nach außen gedrückt werden können und ihrerseits die anliegende Vorspannfeder 30 weiter anspannen. In die Spannmutter 32 kann nach den Figuren 2 und 4 vorteilhaft ein einstellbarer Überlastbolzen 34 eingesetzt werden, der den Weg des Stempels 24 begrenzt. Kontermutter 35 sichert die Schraubverbindung und eignet sich zum Klemmen der Meßleitungen in einer Nut der Spannmutter 32, die in den Figuren 2 und 4 angedeutet ist.

Das Widerlager 29, das Gehäuse 23 und die Membran 22 sind schweißtechnisch auf der druckzugewandten Seite des Aufnehmers verbunden. Gewinde und Dichtfläche am Gehäuse 23 dienen dem Einbau in eine Indizierbohrung an Brennkraftmaschinen. Ein unteres Gehäuseteil 33 ist schweißtechnisch mit dem Aufnehmergehäuse 23 verbunden. Dieses untere Teil enthält einen mit Teflon isolierten und gedichteten Miniaturstecker, bestehend aus Teflonteil 41, Steckerstift 42, Hülse 43, Dichtung 44 und Sicherungsmutter 45.

Es hat sich gezeigt, daß der Druckaufnehmer die gestellten Anforderungen weitgehend erfüllt und die Erfindung gute Ergebnisse im Rahmen der zugrunde gelegten Aufgabenstellung liefert.

**Patentansprüche**

1. Druckaufnehmer mit einem piezoelektrischen Meßelement für Druckmessungen unter hohen Temperaturen, bei dem der zu messende Druck auf mindestens ein piezoelektrisches Meßelement (17, 27) eine Schubspannung ausübt, welche auf der einen Seite des piezoelektrischen Meßelements (17, 27) durch einen Stempel (14, 24) übertragen wird, und bei dem auf der anderen Seite des piezoelektrischen Meßelements (17, 27) ein Widerlager (19, 29) angeordnet ist, das die Kraft aufnimmt und zum Gehäuse (13, 23) weiterleitet, wobei der Stempel (14, 24), das piezoelektrische Meßelement (17, 27) und das Widerlager (19, 29) in Querrichtung unter Vorspannung gehalten sind, dadurch gekennzeichnet, daß das Widerlager (19, 29) in Richtung der dem zu messenden Druck proportionalen Kraft mit dem Gehäuse (13, 23) verbunden ist.

2. Druckaufnehmer nach Anspruch 1, dadurch gekennzeichnet, daß das Widerlager (19, 29) auf der dem zu messenden Druck zugewandten Seite mit dem Gehäuse (13, 23) verbunden ist.

3. Druckaufnehmer nach Anspruch 1 oder 2, dadurch gekennzeichnet, daß bei im wesentlichen symmetrischer Ausbildung zwei einander gegenüberliegende Widerlager (19, 29) von einer Vorspannfeder (20, 30) umgeben sind, deren Vorspannung unabhängig von der Kraft ist, welche dem zu messenden Druck proportional ist.

4. Druckaufnehmer nach einem der Ansprüche 1-3, dadurch gekennzeichnet, daß das Widerlager (19, 29) unmittelbar die Gegenkraft zu der Kraft aufnimmt, welche dem zu messenden Druck proportional ist.

5. Druckaufnehmer nach einem der Ansprüche 1-4, dadurch gekennzeichnet, daß das Widerlager (19, 29) im wesentlichen linienförmig an einem am piezoelektrischen Meßelement (17, 27) anliegenden Krafteinleitungselement (18, 28) anliegt.

6. Druckaufnehmer nach Anspruch 5, dadurch gekennzeichnet, daß das Krafteinleitungselement (18, 28) aus keramischem Material besteht.

7. Druckaufnehmer nach einem der Ansprüche 1-6, dadurch gekennzeichnet, daß das piezoelektrische Meßelement (17, 27) aus einem Lithiumniobat-Einkristall mit einem Kristallschnitt von (xyt) $\psi = 22°—22,5°$ besteht.

**Revendications**

1. Capteur de pression comprenant un élément de mesure piézo-électrique pour mesurer des pressions à haute température, dans lequel la pression à mesurer exerce sur au moins un élément de mesure piézo-électrique (17, 27) une contrainte de cisaillement qui est transmise par un poinçon (14, 24) à l'un des côtés de l'élément de mesure piézo-électrique (17, 27), et dans lequel est disposé, sur l'autre côté de l'élément de mesure piézo-électrique (17, 27), un contreappui (19, 29) qui reçoit la force et qui la transmet au carter (13, 23), le poinçon (14, 24), l'élément de mesure piézo-électrique (17, 27) et le contre-appui (19, 29) étant maintenus sous une précontrainte dans la direction transversale, caractérisé par le fait que le contre-appui (19, 29) est relié au carter (13, 23) dans la direction de la force proportionnelle à la pression à mesurer.

2. Capteur de pression selon la revendication 1, caractérisé par le fait que le contre-appui (19, 29) est relié au carter (13, 23) sur le côté qui est tourné vers la pression à mesurer.

3. Capteur de pression selon la revendication 1 ou 2, caractérisé par le fait que, dans une conformation pour l'essentiel symétrique, deux contre-appuis opposés l'un à l'autre (19, 29) sont entourés par un ressort de précontrainte (20, 30) dont la précontrainte est indépendante de la force proportionnelle à la pression à mesurer.

4. Capteur de pression selon l'une des revendications 1—3, caractérisé par le fait que le contre-appui (19, 29) reçoit directement la force de réaction à la force proportionnelle à la pression à mesurer.

5. Capteur de pression selon l'une des revendications 1—4, caractérisé par le fait que le contre-appui (19, 29) porte pour l'essentiel selon une ligne sur un élément d'introduction de la force (18, 28) qui porte sur l'élément de mesure piézo-électrique (17, 27).

6. Capteur de pression selon la revendication 5, caractérisé par le fait que l'élément d'introduction de la force (18, 28) se compose d'un matériau céramique.

7. Capteur de pression selon l'une des revendications 1—6, caractérisé par le fait que l'élément de mesure piézoélectrique (17, 27) se compose d'un monocristal de niobate de lithium avec une coupe du cristal à (xyz) $\psi = 22°—22,5°$.

**Claims**

1. A pressure sensor comprising a piezoelectric measuring element for measuring pressures at high temperatures, in which the pressure to be measured subjects at least one piezoelectric measuring element (17, 27) to a shear stress which is transmitted on one side of the piezoelectric measuring element (17, 27) by a plunger (14, 24), an abutment (19, 29) being disposed on the other side of the piezoelectric measuring element (17, 27) and receiving the force and transmitting it to a casing (13, 23), and the plunger (14, 24), the piezoelectric measuring element (17, 27) and the abutment (19, 29) being held under prestress in the transverse direction, characterised in that the abutment (19, 29) is connected to the casing (13, 23) in the direction of the force proportional to the pressure to be measured.

2. A pressure sensor according to claim 1, characterised in that the abutment (19, 29) is connected to the casing (13, 23) on the side facing the pressure to be measured.

3. A pressure sensor according to claim 1 or 2, characterised in that in a substantially symmetrical construction, two facing abutments (19, 29) are surrounded by a prestressing spring (20, 30) having a prestress which is independent of the force proportional to the pressure to be measured.

4. A pressure sensor according to any of claims 1 to 3, characterised in that the abutment (19, 29) directly receives the force in reaction to the force which is proportional to the pressure to be measured.

5. A pressure sensor according to any of claims 1 to 4, characterised in that the abutment (19, 29) is in approximately linear contact with a force-introducing element (18, 28) abutting the piezoelectric measuring element (17, 27).

6. A pressure sensor according to claim 5, characterised in that the force-introducing element (18, 28) is made of ceramic material.

7. A pressure sensor according to any of claims 1 to 6, characterised in the piezoelectric measuring element comprises a lithium niobate monocrystal having a crystal cut of (xyt) $\psi = 22°—22.5°$.

FIG.1

FIG.2

FIG.3

FIG.4

FIG.5